# EUROPEAN PATENT APPLICATION

(11) **EP 4 661 295 A1**
(43) Date of publication of application: **10.12.2025**
(21) Application number: 24766357.8
(22) Date of filing: 01.03.2024
(51) Int. Cl.: H03L 7/107

(54) **DATA AND CLOCK RECOVERY CIRCUIT, RECEIVING APPARATUS, VEHICLE-MOUNTED DEVICE AND VEHICLE**

(30) Priority: 09.03.2023 CN 202310275620
(71) Applicant: Huawei Technologies Co., Ltd., Shenzhen, Guangdong 518129 (CN)
(72) Inventor: TAO, Minghui, Shenzhen, Guangdong 518129 (CN)
(74) Representative: Goddar, Heinz J.
(86) International application number: PCT/CN2024/079612
(87) International publication number: WO 2024/183641

(57) **Abstract**

A data and clock recovery circuit (110), a receiving apparatus (100), a circuit system (1000), a vehicle-mounted device (11), a vehicle (10), and a data and clock recovery method are provided. The data and clock recovery circuit (110) includes a sampler (111), a phase detector (112), a multi-order filter (113), a frequency change detection circuit (114), and a selector (115). The sampler (111) is configured to sample an input signal based on a multi-order filtered signal to generate a sampled signal. The phase detector (112) is configured to determine a phase detector in the sampled signal based on the sampled signal. The multi-order filter (113) is configured to generate the multi-order filtered signal based on the phase difference. The frequency change detection circuit (114) is configured to determine a frequency change direction of a spread spectrum clock in the input signal by using the phase difference. The selector (115) is configured to: in response to the frequency change detection circuit (114) indicating that the frequency change direction changes, invalidate a slope branch in the multi-order filter (113) for a predetermined time period. Therefore, a tracking speed and tracking precision of the spread spectrum clock can be effectively improved at a signal receiving end.

## Description

### TECHNICAL FIELD

This disclosure mainly relates to the field of electronic and circuit technologies, and more specifically, to a data and clock recovery circuit, a receiving apparatus, a circuit system, a vehicle-mounted device, a vehicle, and a data and clock recovery method.

### BACKGROUND

A circuit system may generate electromagnetic interference (electromagnetic interference, EMI) to a surrounding circuit system through conduction or radiation. The EMI may degrade circuit performance of the affected system, or even invalidate the entire system. In a scenario such as a vehicle-mounted network that includes a large quantity of electronic devices, there is usually a mandatory requirement for the EMI, to avoid impact on system performance and security caused by mutual interference between electronic devices. Currently, there are many methods to reduce the EMI, such as shielding, filtering, isolation, a ferrite magnetic ring, signal edge control, and adding a power supply and a ground layer in a printed circuit board (printed circuit board, PCB). However, these methods all have some clear defects, for example, shielding is simple, but costs are high and a size is large, and cannot be applied to handheld and portable devices; filtering and signal edge control are effective only for low-frequency signals and cannot be applied to high-speed signals that are widely used currently; use of passive components such as an EMI filter or a radio frequency interference (radio frequency interference, RFI) filter increases costs; and reducing the EMI by using a PCB layout technology may cause an increase in design difficulty and costs and requires a customized design, and portability is poor.

Spread spectrum clocking (spread spectrum clocking, SSC) is another effective method for reducing the EMI. In the circuit system, a clock signal has a highest frequency and a steepest edge. Therefore, many EMI problems are related to the clock signal. The spread spectrum clocking spreads energy concentrated in a narrow frequency band range to a specified wide frequency band range through frequency modulation. In this way, amplitude or energy of a clock at a fundamental frequency and an odd harmonic frequency is reduced, to reduce a peak value for electromagnetic radiation of the system. Compared with other EMI reduction methods, an SSC technology has advantages such as a good EMI suppression effect, low costs, and strong portability. However, when the SSC technology is applied to a transmitting end to reduce EMI impact of the system, some problems are also caused to signal receiving at a receiving end. For example, a clock signal for which the SSC technology is used has a large frequency offset, which may cause a problem that a signal cannot be tracked or tracking precision is poor at the receiving end. In addition, in some scenarios such as the vehicle-mounted network, severe channel attenuation occurs, which further deteriorates tracking precision in a spread spectrum mode, and causes deterioration of overall system performance.

### SUMMARY

To resolve the foregoing problem, embodiments of this disclosure provide a data and clock recovery circuit, a data and clock recovery method, a receiving apparatus including the data and clock recovery circuit, a circuit system, a vehicle-mounted device, and a vehicle.

According to a first aspect of this disclosure, a data and clock recovery circuit is provided. The data and clock recovery circuit includes: a sampler, configured to sample an input signal based on a multi-order filtered signal to generate a sampled signal; a phase detector, configured to determine a phase difference in the sampled signal based on the sampled signal; a multi-order filter, configured to generate the multi-order filtered signal based on the phase difference; a frequency change detection circuit, configured to determine a frequency change direction of a spread spectrum clock in the input signal by using the phase difference; and a selector, configured to: in response to the frequency change detection circuit indicating that the frequency change direction changes, invalidate a slope branch in the multi-order filter for a predetermined time period.

In the solution of this disclosure, multi-order filtering is set, and the slope branch or a slope operation in the multi-order filtering is temporarily invalidated when the frequency change direction of the spread spectrum clock changes, so that overshoot occurring in a tracking process of the spread spectrum clock can be effectively alleviated or eliminated, and the spread spectrum clock and data are recovered with higher precision, to improve overall performance of a signal receiving end and a system.

In an implementation of the first aspect, the multi-order filter further includes a proportion branch and an integration branch, and the frequency change detection circuit is configured to determine the frequency change direction based on a first integrated signal generated by the integration branch. In this implementation, a phase difference offset and an error variance can be effectively reduced, to implement a high tracking speed and high tracking precision for a spread spectrum clock with a large frequency offset. In addition, a frequency change of the spread spectrum clock may be accurately obtained by using the first integrated signal generated by the integration branch.

In an implementation of the first aspect, the frequency change detection circuit includes: a differentiator, configured to generate a differential signal based on the first integrated signal; a first filter, configured to generate a first filtered signal based on the differential signal; and a first symbol decider, configured to generate, based on the first filtered signal, a decision signal indicating the frequency change direction. In this implementation, the frequency change direction of the spread spectrum clock can be effectively determined.

In an implementation of the first aspect, the frequency change detection circuit includes: a first adder, configured to calculate a difference between the first integrated signal and a second filtered signal to generate a difference signal; an integrator, configured to generate a second integrated signal based on the difference signal; a second filter, configured to generate the second filtered signal based on the second integrated signal; and a second symbol decider, configured to generate, based on the second integrated signal, a decision signal indicating the frequency change direction. In this implementation, the frequency change direction of the spread spectrum clock can be effectively determined.

In an implementation of the first aspect, the selector includes: a multiplexer, including a first input end for receiving a constant signal, a second input end for receiving a slope signal generated by the slope branch, an output end, and a selection end, where the multiplexer is configured to separately output the constant signal or the slope signal at the output end based on that a selection signal input to the selection end is a first level or a second level; and a jump detection circuit, configured to: in response to the frequency change detection circuit indicating that the frequency change direction changes, output a selection signal of the first level to the selection end for the predetermined time period, and output a selection signal of the second level to the selection end in another time period other than the predetermined time period. In this implementation, the slope branch in the multi-order filter may be conveniently invalidated for the predetermined time period, to alleviate or eliminate an overshoot problem.

In an implementation of the first aspect, the jump detection circuit includes: a delay circuit, configured to delay, by duration of the predetermined time period, a signal indicating the frequency change direction; and an exclusive-OR logic part, configured to perform an exclusive-OR operation on the signal indicating the frequency change direction and the delayed signal to generate the selection signal. In this implementation, a jump in the frequency change direction of the spread spectrum clock can be accurately detected, and selection control on the multiplexer is implemented based on jump detection.

In an implementation of the first aspect, the data and clock recovery circuit further includes: an equalizer, configured to equalize the sampled signal, where the phase detector is further configured to determine the phase difference in the sampled signal based on an equalized sampled signal. In this implementation, a high-frequency component and a low-frequency component in the sampled signal may be equalized, to compensate for inter-symbol interference caused by link transmission, thereby effectively improving phase detection precision and tracking precision.

In an implementation of the first aspect, the equalizer includes: a feed forward equalization part, configured to generate a feed forward equalized signal based on the sampled signal; a feedback equalization part, configured to generate a feedback equalized signal based on the feed forward equalized signal; and a second adder, configured to calculate a difference between the feed forward equalized signal and the feedback equalized signal to generate the equalized sampled signal. In this implementation, high-frequency noise can be filtered out while the high-frequency component is improved, thereby improving phase detection precision and tracking precision.

In an implementation of the first aspect, the data and clock recovery circuit further includes: a decider, configured to determine a decision value of the sampled signal based on the equalized sampled signal, where the phase detector is further configured to determine the phase difference in the sampled signal based on the decision value, and the equalizer is further configured to equalize the sampled signal based on the decision value that is fed back. In this implementation, phase detection precision of the phase detector can be further improved, thereby improving overall performance of the circuit.

In an implementation of the first aspect, the predetermined time period is associated with overshoot duration of a slope signal generated by the slope branch when the frequency change direction changes. In this implementation, overshoot impact can be avoided to a maximum extent or even eliminated.

In an implementation of the first aspect, the sampler includes: a controlled oscillator or a phase interpolator, configured to determine a sampling frequency based on the multi-order filtered signal; and an analog-to-digital converter, configured to sample the input signal at the determined sampling frequency. In this implementation, the sampling frequency can be determined simply and efficiently and data information can be recovered from the input signal.

According to a second aspect of this disclosure, a receiving apparatus is provided. The receiving apparatus includes: the data and clock recovery circuit according to the first aspect, and a data processing circuit, configured to process data output by the data and clock recovery circuit.

According to a third aspect of this disclosure, a circuit system is provided. The circuit system includes: the receiving apparatus according to the second aspect, and a sending apparatus, configured to transmit a signal to the receiving apparatus in a clock spread spectrum manner.

According to a fourth aspect of this disclosure, a vehicle-mounted device is provided. The vehicle-mounted device includes: a circuit board, and the receiving apparatus according to the second aspect, mounted on the circuit board.

According to a fifth aspect of this disclosure, a vehicle is provided. The vehicle includes: the vehicle-mounted device according to the fourth aspect, and a power supply apparatus, configured to supply power to the vehicle-mounted device.

According to a sixth aspect of this disclosure, a data and clock recovery method is provided, including: sampling an input signal based on a multi-order filtered signal to generate a sampled signal; determining a phase difference in the sampled signal based on the sampled signal; performing multi-order filtering on a signal representing the phase difference to generate the multi-order filtered signal; determining a frequency change direction of a spread spectrum clock in the input signal by using the phase difference in a process of performing the multi-order filtering; and invalidating a slope operation in the multi-order filtering for a predetermined time period in response to a change of the frequency change direction.

In an implementation of the sixth aspect, the multi-order filtering further includes a proportion operation and an integration operation, and the determining a frequency change direction of a spread spectrum clock in the input signal by using the phase difference includes: determining the frequency change direction based on a first integrated signal generated by the integration operation.

In an implementation of the sixth aspect, the determining a frequency change direction of a spread spectrum clock in the input signal by using the phase difference includes: performing differential on the first integrated signal to generate a differential signal; filtering the differential signal to generate a first filtered signal; and performing a symbol decision on the first filtered signal to generate a decision signal indicating the frequency change direction.

In an implementation of the sixth aspect, the determining a frequency change direction of a spread spectrum clock in the input signal by using the phase difference includes: calculating a difference between the first integrated signal and a second filtered signal to generate a difference signal; performing integration on the difference signal to generate a second integrated signal; filtering the second integrated signal to generate the second filtered signal; and performing a symbol decision on the second integrated signal to generate a decision signal indicating the frequency change direction.

In an implementation of the sixth aspect, the invalidating a slope operation in the multi-order filtering for a predetermined time period in response to a change of the frequency change direction includes: superimposing a constant signal into the integration operation for the predetermined time period in response to the change of the frequency change direction; and the method further includes: superimposing, into the integration operation in another time period other than the predetermined time period, a slope signal generated by the slope operation.

In an implementation of the sixth aspect, the method further includes: equalizing the sampled signal; and the determining a phase difference in the sampled signal based on the sampled signal includes: determining the phase difference in the sampled signal based on an equalized sampled signal.

In an implementation of the sixth aspect, the equalizing the sampled signal includes: performing feed forward equalization on the sampled signal to generate a feed forward equalized signal; performing feedback equalization on the feed forward equalized signal to generate a feedback equalized signal; and calculating a difference between the feed forward equalized signal and the feedback equalized signal to generate the equalized sampled signal.

In an implementation of the sixth aspect, the method further includes: determining a decision value of the sampled signal based on the equalized sampled signal; the determining a phase difference in the sampled signal based on the sampled signal includes: determining the phase difference in the sampled signal based on the decision value; and the equalizing the sampled signal includes: equalizing the sampled signal based on the decision value that is fed back.

In an implementation of the sixth aspect, the predetermined time period is associated with duration of overshoot caused by the slope operation when the frequency change direction changes.

In an implementation of the sixth aspect, the sampling an input signal based on a multi-order filtered signal to generate a sampled signal includes: determining a sampling frequency based on the multi-order filtered signal; and sampling the input signal at the determined sampling frequency.

According to a seventh aspect of this disclosure, a chip is provided. The chip includes the data and clock recovery circuit according to the first aspect, and a data processing circuit, and the data processing circuit is configured to process data output by the data and clock recovery circuit.

The receiving apparatus according to the second aspect, the circuit system according to the third aspect, the vehicle-mounted device according to the fourth aspect, the vehicle according to the fifth aspect, the method according to the sixth aspect, and the chip according to the seventh aspect that are provided above include or relate to the data and clock recovery circuit according to the first aspect. Therefore, the explanations or descriptions of the first aspect is also applicable to the second aspect to the seventh aspect. In addition, for beneficial effects that can be achieved according to the second aspect to the seventh aspect, refer to the beneficial effects according to the first aspect. Details are not described herein again. In this application, based on the implementations provided in the foregoing aspects, the implementations may be further combined to provide more implementations.

### BRIEF DESCRIPTION OF DRAWINGS

With reference to the accompanying drawings and the following detailed descriptions, the foregoing and other features, advantages, and aspects of embodiments of this disclosure become more apparent. In the accompanying drawings, same or similar reference numerals indicate same or similar elements.
FIG. 1 is a diagram of a vehicle according to an embodiment of this disclosure;
FIG. 2 is a diagram of a circuit system according to an embodiment of this disclosure;
FIG. 3 is a waveform diagram of a spread spectrum clock and clock recovery modules for which a plurality of types of loops are used;
FIG. 4 is a block diagram of a data and clock recovery circuit according to an embodiment of this disclosure;
FIG. 5 is a block diagram of a sampler in a data and clock recovery circuit according to an embodiment of this disclosure;
FIG. 6 is a block diagram of a multi-order filter, a frequency change detection circuit, and a selector in a data and clock recovery circuit according to an embodiment of this disclosure;
FIG. 7 is a block diagram of an implementation of a frequency change detection circuit in a data and clock recovery circuit according to an embodiment of this disclosure;
FIG. 8 is a block diagram of another implementation of a frequency change detection circuit in a data and clock recovery circuit according to an embodiment of this disclosure;
FIG. 9 is a block diagram of a selector according to an embodiment of this disclosure;
FIG. 10 is a waveform diagram of a first integrated signal and an input signal and an output signal of an exclusive-OR logic part in a data and clock recovery circuit according to an embodiment of this disclosure;
FIG. 11 is a block diagram of a data and clock recovery circuit according to another embodiment of this disclosure;
FIG. 12 is a block diagram of an equalizer in a data and clock recovery circuit according to another embodiment of this disclosure;
FIG. 13 is a schematic flowchart of a data and clock recovery method according to an embodiment of this disclosure;
FIG. 14 is a schematic flowchart of a method for determining a frequency change direction of a spread spectrum clock according to an embodiment of this disclosure; and
FIG. 15 is a schematic flowchart of another method for determining a frequency change direction of a spread spectrum clock according to an embodiment of this disclosure.

### DESCRIPTION OF EMBODIMENTS

Embodiments of this disclosure are described in more detail below with reference to the accompanying drawings. Although some embodiments of this disclosure are shown in the accompanying drawings, it should be understood that this disclosure can be implemented in various forms, and should not be construed as being limited to embodiments described herein, and instead, these embodiments are provided for a more thorough and complete understanding of this disclosure. It should be understood that the accompanying drawings and embodiments of this disclosure are merely used as examples and are not intended to limit the protection scope of this disclosure.

In the descriptions of embodiments of this disclosure, the term "including" and similar terms thereof should be understood as non-exclusive inclusions, that is, "include but are not limited to". The term "based on" should be understood as "at least partially based on". The term "one embodiment" or "this embodiment" should be understood as "at least one embodiment". The terms "first", "second", and the like may indicate different objects or a same object. Other explicit and implicit definitions may also be included below.

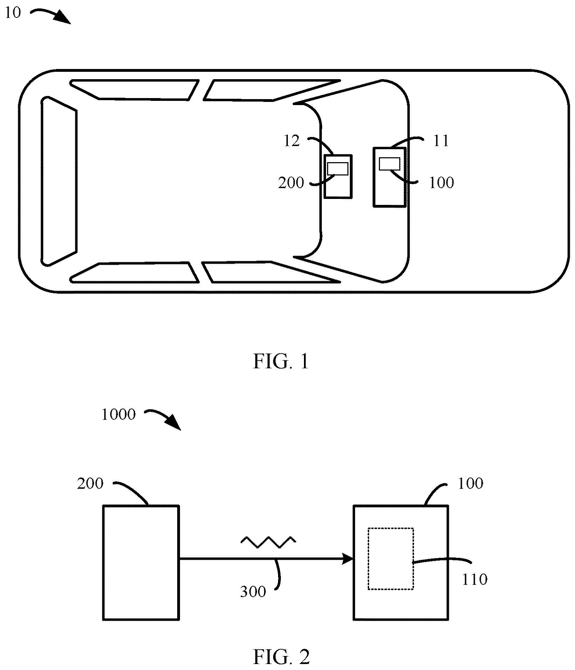

FIG. 1 is a diagram of a vehicle 10 according to an embodiment of this disclosure. As shown in FIG. 1, the vehicle 10 includes vehicle-mounted devices 11 and 12. For example, the vehicle-mounted device 11 may be a control console of the vehicle 10, and the vehicle-mounted device 12 may be a vehicle-mounted camera or a vehicle-mounted radar. The vehicle-mounted device 11 may include a receiving apparatus 100 and a circuit board (not shown) on which the receiving apparatus 100 is mounted. The vehicle-mounted device 12 may include a sending apparatus 200 and a circuit board (not shown) on which the sending apparatus 200 is mounted. In addition, the vehicle 10 may further include a power supply apparatus configured to supply power to the vehicle-mounted devices 11 and 12. It may be understood that the vehicle-mounted devices 11 and 12 are not limited to the control console, the vehicle-mounted camera, and the vehicle-mounted radar, but may be any device that can perform communication in the vehicle 10. In addition, the vehicle 10 may further include another vehicle-mounted device that is not shown. Therefore, these vehicle-mounted devices may form an vehicle-mounted network in the vehicle 10 to perform data exchange, and may implement a plurality of functions in the vehicle 10, for example, assisting vehicle driving.

FIG. 2 is a diagram of a circuit system 1000 according to an embodiment of this disclosure. As shown in FIG. 2, the circuit system 1000 includes the receiving apparatus 100 and the sending apparatus 200 in FIG. 1 and a channel 300. The sending apparatus 200 transmits a signal or data to the receiving apparatus 100 through the channel 300. In other words, the receiving apparatus 100, the sending apparatus 200, and the channel 300 between the receiving apparatus 100 and the sending apparatus 200 may form a communication system, to implement data transmission from a vehicle-mounted device 12 to a vehicle-mounted device 11. It may be understood that the circuit system 1000 may further include more sending apparatuses and receiving apparatuses, for example, include another sending apparatus and another receiving apparatus that are configured to reversely transmit a signal or data from the vehicle-mounted device 11 to the vehicle-mounted device 12, or a sending apparatus and a receiving apparatus of another vehicle-mounted device. Further, the circuit system 1000 is not limited to a system in a vehicle, but may be a system in any scenario in which data communication or exchange is performed.

As described above, radiation and conduction of the circuit system may cause EMI to another system and device, and a system clock signal is an important cause of an EMI problem. Generally, a system clock has a very high quality factor value, that is, all energy is concentrated in a narrow frequency range, and is represented as a high energy peak value. There is a very high peak value in a middle frequency of a spectrum graph and a low peak value in an odd harmonic position. An SSC technology can reduce peak value energy by increasing a clock bandwidth and reduce a quality factor value of a digital clock, to effectively reduce the EMI of the system.

According to this embodiment of this disclosure, the sending apparatus 200 of the circuit system 1000 may be configured to transmit a signal to the receiving apparatus 100 in a clock spread spectrum manner. Specifically, the sending apparatus 200 may modulate a clock signal, to periodically change a frequency or a periodicity of the clock signal. For example, the sending apparatus 200 may gradually increase the frequency of the clock signal (that is, gradually shorten the periodicity of the clock signal), and gradually decrease the frequency of the clock signal (that is, gradually increase the periodicity of the clock signal) after several periodicities. A modulated wave used to modulate the clock signal includes but is not limited to a triangular wave, a sine wave, a Hershey-Kiss wave, and the like, and a modulation scheme includes but is not limited to a center spread spectrum, an up spread spectrum, a down spread spectrum, and the like. A change frequency of a frequency of a modulated clock signal is referred to as a modulation frequency, and the modulation frequency may usually reach 30 Hz to 120 Hz. An offset of a frequency of the modulated clock signal relative to an original clock frequency is referred to as a modulation depth. For example, when the original clock frequency is fc and the offset of the frequency of the modulated clock signal is Δfc, the modulation depth δ may be represented as δ=Δfc/fc. Generally, a larger modulation depth of the spread spectrum clock indicates more radiation reduction, and therefore, a better EMI reduction effect is achieved. Therefore, the modulation depth of the spread spectrum clock may reach thousands or even tens of thousands of ppm (parts per million).

The SSC technology poses a great challenge to digital clock recovery at a signal receiving end. The spread spectrum clock has a larger frequency offset range, and a larger modulation depth indicates a larger frequency offset of a clock signal. A clock recovery module used by a conventional signal receiving end usually recovers a clock with a fixed frequency offset by using an analog or digital technology. Such a clock recovery module cannot quickly and accurately track a spread spectrum clock signal with a frequency offset or a modulation depth of thousands or tens of thousands of ppm. If a bandwidth is increased to track the SSC with the large frequency offset, extra jitter and noise may be introduced, resulting in a decrease in tracking precision. Due to factors such as an adverse channel, an echo, and interference, the clock recovery module of the SSC may be coupled to and compete with equalization, echo cancellation, and other processing, which deteriorates robustness of the system. In addition, in a higher-order modulation system, the SSC may further adversely affect phase detection precision.

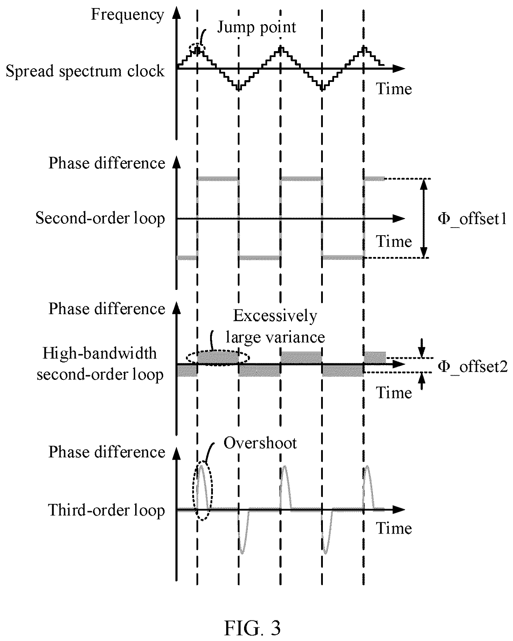

FIG. 3 is a waveform diagram of an example of a spread spectrum clock and clock recovery modules for which a plurality of types of loops are used. A 1^{st} waveform diagram in FIG. 3 shows a waveform in which a frequency of a clock signal for which an SSC technology is used changes with time, and a 2^{nd} waveform diagram to a 4^{th} waveform diagram in FIG. 3 respectively show waveforms in which phase differences of signals output by clock recovery modules for which a conventional second-order loop, a high-bandwidth second-order loop, and a third-order loop are used change with time.

As shown in FIG. 3, a triangular wave is used as a modulation wave for the spread spectrum clock, so that the frequency of the clock signal periodically increases and decreases in a form of the triangular wave. Because a bandwidth of the conventional second-order loop is limited and a signal with a large frequency offset cannot be tracked, the phase difference of the signal output by the clock recovery module for which the conventional second-order loop is used has a large phase difference offset Φ_offset1. When the high-bandwidth second-order loop is used for the clock recovery module, a phase difference offset decreases from Φ_offset1 to Φ_offset2. However, with increase of a loop bandwidth, loop anti-noise performance deteriorates, and consequently, an error variance of the signal increases, which still severely affects tracking precision. Further, a slope operation is introduced into the third-order loop. The slope operation helps track a change frequency of the spread spectrum clock, which reduces a phase difference offset and further reduces an error variance, thereby effectively improving a tracking speed and tracking precision of the clock signal with the large frequency offset. However, research shows that a problem still exists in the third-order loop or a multi-order loop that includes the slope operation. For example, clear overshoot exists in a tracking process of the third-order loop, and the overshoot causes severe deterioration of the tracking precision.

In addition, the conventional clock recovery module is mainly used in unidirectional transmission and a non-return to zero (non-return to zero, NRZ) coding modulation system, and is less concerned in high-order modulation systems with 4-level pulse amplitude modulation (4-Level Pulse Amplitude Modulation, PAM4) and above and a bidirectional symmetric system. In a vehicle-mounted network for which high-order modulation such as PAM4 is used, a transmission channel condition is poor, and severe inter-symbol interference is generated. Consequently, a conventional module has a poor effect of tracking and recovering a spread spectrum clock and data.

Embodiments of this disclosure provide an improved solution for recovering data and a clock in a circuit system for which an SSC technology is used. In the improved solution, multi-order filtering is set, and a slope branch or a slope operation in the multi-order filtering is temporarily invalidated (deactivated) when a frequency change direction of a spread spectrum clock changes, so that overshoot occurring in a tracking process of the spread spectrum clock can be effectively alleviated or eliminated, and the spread spectrum clock and the data are recovered with higher precision. In addition, the solution of this disclosure can further alleviate an inter-symbol interference problem and improve phase detection precision of a phase detector, thereby further improving tracking precision. According to the solution of this disclosure, the clock signal can be recovered with high precision in the vehicle-mounted network with the poor transmission channel, the high-order modulation system, and the bidirectional symmetric system, to improve overall performance of a signal receiving end and a system.

According to an embodiment of this disclosure, the receiving apparatus 100 includes a data and clock recovery circuit 110. The data and clock recovery circuit 110 may perform data and clock recovery on an SSC-modulated signal of the sending apparatus 200. In addition, the receiving apparatus 100 may further include a data processing circuit. The data processing circuit is configured to process data output by the data and clock recovery circuit 110. For example, a signal from the vehicle-mounted camera is received by the receiving apparatus 100 in the control console of the vehicle, and the data and clock recovery circuit 110 and the data processing circuit perform data recovery and processing on the received signal, so that the control console may obtain information captured by the vehicle-mounted camera.

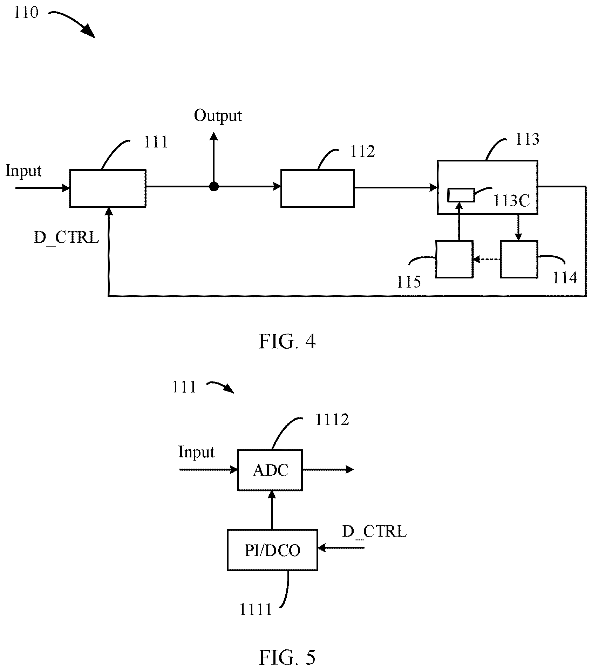

FIG. 4 is a block diagram of a data and clock recovery circuit 110 according to an embodiment of this disclosure. As shown in FIG. 4, the data and clock recovery circuit 110 includes a sampler 111, and the sampler 111 samples an input signal based on a multi-order filtered signal D_CTRL to generate a sampled signal. Specifically, a signal from a sending apparatus 200 may be transmitted to the data and clock recovery circuit 110 of a receiving apparatus 100 through a channel 300, and is input to the sampler 111 as the input signal. In addition, the sampler 111 further receives the multi-order filtered signal D_CTRL fed back by a loop, determines a sampling frequency based on the multi-order filtered signal D_CTRL, and samples the input signal. The sampled signal generated by the sampler 111 may be used as an output signal of the data and clock recovery circuit 110 and output to a data processing circuit of the receiving apparatus 100 or another external device.

FIG. 5 is a block diagram of a sampler 111 in a data and clock recovery circuit 110 according to an embodiment of this disclosure. In some embodiments of this disclosure, the sampler 111 may include a controlled oscillator or a phase interpolator 1111 and an analog-to-digital converter 1112. The controlled oscillator or the phase interpolator 1111 determines a sampling frequency based on a multi-order filtered signal D_CTRL, and the analog-to-digital converter 1112 samples an input signal at the determined sampling frequency. In this manner, the sampler 111 may determine the sampling frequency in a simple and efficient manner and determine and recover data information from the input signal.

According to this embodiment of this disclosure, the data and clock recovery circuit 110 includes a phase detector 112 and a multi-order filter 113. The phase detector 112 determines a phase difference in the sampled signal based on the sampled signal generated by the sampler 111, and the multi-order filter 113 generates the multi-order filtered signal D_CTRL based on the determined phase difference. Specifically, the phase detector 112 may receive a sampled output signal, and determine the phase difference through analysis, where the phase difference reflects a difference between a phase or a frequency of the sampled signal of the sampler 111 and an actual phase or frequency of the input signal of the sampler 111. Then, the multi-order filter 113 filters a signal representing the phase difference generated by the phase detector 112 to generate the signal D_CTRL. The multi-order filter 113 includes at least a slope branch 111C, and the slope branch 111C may perform a slope operation on a signal input to the multi-order filter 113, which helps track a change frequency of a spread spectrum clock. It can be learned that the sampler 111, the phase detector 112, and the multi-order filter 113 form a feedback loop. The feedback loop generates a feedback signal based on the sampled signal generated by the sampler 111, and feeds back the feedback signal to the sampler 111, so that the sampling frequency of the sampler 111 can be continuously adjusted based on the phase difference, to ensure accurate sampling of the input signal.

According to this embodiment of this disclosure, the data and clock recovery circuit 110 includes a frequency change detection circuit 114 and a selector 115. The frequency change detection circuit 114 determines a frequency change direction of the spread spectrum clock in the input signal of the data and the clock recovery circuit 110 by using the phase difference output by the phase detector 112, and in response to the frequency change detection circuit 114 indicating that the frequency change direction changes, the selector 115 invalidates the slope branch 113C in the multi-order filter 113 for a predetermined time period.

Specifically, the frequency change detection circuit 114 may detect a frequency change of the spread spectrum clock, to determine whether a clock frequency increases or decreases, and the selector 115 adjusts the multi-order filter 113 based on the frequency change detected by the frequency change detection circuit 114. Research shows that the slope branch 113C in the multi-order filter 113 improves a tracking speed and tracking precision of a spread spectrum clock signal with a large frequency offset. However, at a jump moment (for example, a jump point shown in FIG. 3) at which the frequency change direction of the spread spectrum clock changes from increasing a frequency to decreasing a frequency, in this case, the multi-order filter causes an overshoot problem, which causes deterioration of the tracking precision of the data and clock recovery circuit. Therefore, the jump moment at which the frequency change direction of the spread spectrum clock changes may be determined by disposing the frequency change detection circuit 114 and the selector 115, and the slope branch 113C or the slope operation in the multi-order filter 113 is in an invalid state in a period of time after the jump moment, so that the slope branch 113C is temporarily removed or decoupled from the multi-order filter 113. In this manner, the overshoot problem can be effectively alleviated or eliminated, to obtain a more precise tracking effect.

In some embodiments of this disclosure, the predetermined time period for which the slope branch 113C is invalidated is associated with overshoot duration of a slope signal generated by the slope branch 113C when the frequency change direction of the spread spectrum clock changes. Specifically, at the jump moment at which the frequency change direction of the spread spectrum clock changes, the signal generated by the slope branch 113C in the multi-order filter 113 is in a clear overshoot state. If the slope branch 113C is removed or decoupled from the multi-order filter 113 during a time period in which the slope signal output by the slope branch 113C is in the overshoot state, the overshoot problem in the data and clock recovery circuit can be completely eliminated. Therefore, duration for which the slope branch 113C needs to be invalidated may be determined based on the duration of the overshoot state of the slope signal generated by the slope branch 113C, to avoid overshoot caused by the slope branch to a maximum extent and improve the tracking precision. In an example, the overshoot duration of the slope signal may be determined through pre-detection, real-time detection, or in another appropriate manner.

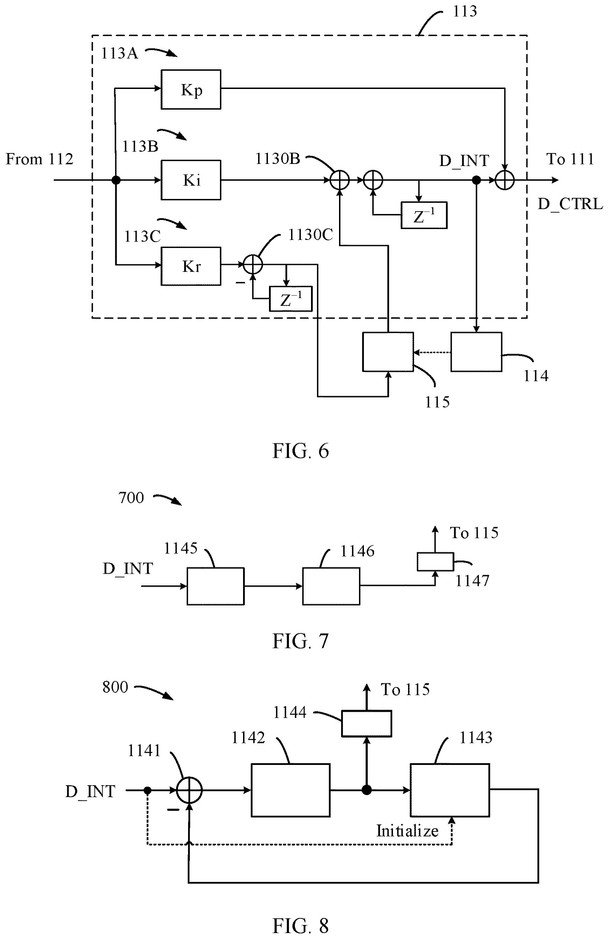

FIG. 6 is a block diagram of a multi-order filter 113, a frequency change detection circuit 114, and a selector 115 in a data and clock recovery circuit 110 according to an embodiment of this disclosure. As shown in FIG. 6, in addition to a slope branch 113C, the multi-order filter 113 may further include a proportion branch 113A and an integration branch 113B. The proportion branch 113A may perform a proportion operation on a signal input to the multi-order filter 113, and the integration branch may perform an integration operation on a signal input to the multi-order filter 113. In other words, the multi-order filter 113 may be a third-order filter including the proportion branch 113A, the integration branch 113B, and the slope branch 113C. Third-order filtering can effectively reduce and alleviate a phase difference offset and an error variance, and implement a high tracking speed and high tracking precision for a spread spectrum clock with a large frequency offset. However, it may be understood that an implementation of the multi-order filter 113 is not limited thereto, and may be another appropriate form of multi-order filter including the slope branch 113C.

In some embodiments of this disclosure, the frequency change detection circuit 114 determines a frequency change direction based on a first integrated signal D_INT generated by the integration branch 113B. Specifically, a frequency change of a spread spectrum clock in an input signal is basically consistent with a change of the first integrated signal D_INT. Therefore, the frequency change direction of the spread spectrum clock may be determined by detecting and analyzing the first integrated signal D_INT, to help accurately detect a jump moment at which the frequency change direction changes.

FIG. 7 is a block diagram of a frequency change detection circuit 700 according to an embodiment of this disclosure. The frequency change detection circuit 700 in FIG. 7 is a non-limiting implementation of the frequency change detection circuit 114 in FIG. 4. As shown in FIG. 7, the frequency change detection circuit 700 includes a differentiator 1145, a first filter 1146, and a first symbol decider 1147. The differentiator 1145 generates a differential signal based on a first integrated signal D_INT, the first filter 1146 generates a first filtered signal based on the generated differential signal, and the first symbol decider 1147 generates, based on the generated first filtered signal, a decision signal indicating a frequency change direction. Specifically, after differential processing is performed on the first integrated signal D_INT, the differential signal indicating a change rate or a slope of the signal may be obtained. After the differential signal is filtered, noise is filtered out, and then a symbol decision is performed on a filtered signal, to obtain the decision signal indicating whether the change rate or the slope is positive or negative. For example, when a frequency of a spread spectrum clock is decreasing, the generated decision signal is at a first level (for example, a high level) indicating that the change rate or the slope is negative; or when a frequency of a spread spectrum clock is increasing, the generated decision signal is at a second level (for example, a low level) indicating that the change rate or the slope is positive. In this manner, the frequency change direction of the spread spectrum clock can be effectively determined, to help further determine a jump that occurs when the frequency change direction changes.

FIG. 8 is a block diagram of a frequency change detection circuit 800 according to an embodiment of this disclosure. The frequency change detection circuit 800 in FIG. 8 is another non-limiting implementation of the frequency change detection circuit 114 in FIG. 4. As shown in FIG. 8, the frequency change detection circuit 800 includes a first adder 1141, an integrator 1142, a second filter 1143, and a second symbol decider 1144. The first adder 1141 calculates a difference between a first integrated signal D_INT and a second filtered signal that is generated by the second filter 1143 to generate a difference signal, the integrator 1142 generates a second integrated signal based on the generated difference signal, the second filter 1143 generates a second filtered signal based on the second integrated signal, and the second symbol decider 1144 generates, based on the second integrated signal, a decision signal indicating a frequency change direction. In an embodiment, initialization setting may be performed on the second filter 1143 by using the first integrated signal D_INT, for example, initialization setting is performed on a delay section in an integration operation of the second filter 1143. After being appropriately set, the second filter 1143 filters the second integrated signal generated by the integrator 1142 to generate the second filtered signal equal to an average value of the first integrated signal D_INT. Therefore, the signal generated by the difference operation of the first adder 1141 is actually a difference between the first integrated signal D_INT and the average value of the first integrated signal D_INT. The integrator 1142 performs integration on the difference, and a moment at which an integration result crosses zero means that the frequency change direction of a spread spectrum clock jumps. The decision signal obtained after a symbol decision is performed on the integral result indicates the frequency change direction of the spread spectrum clock.

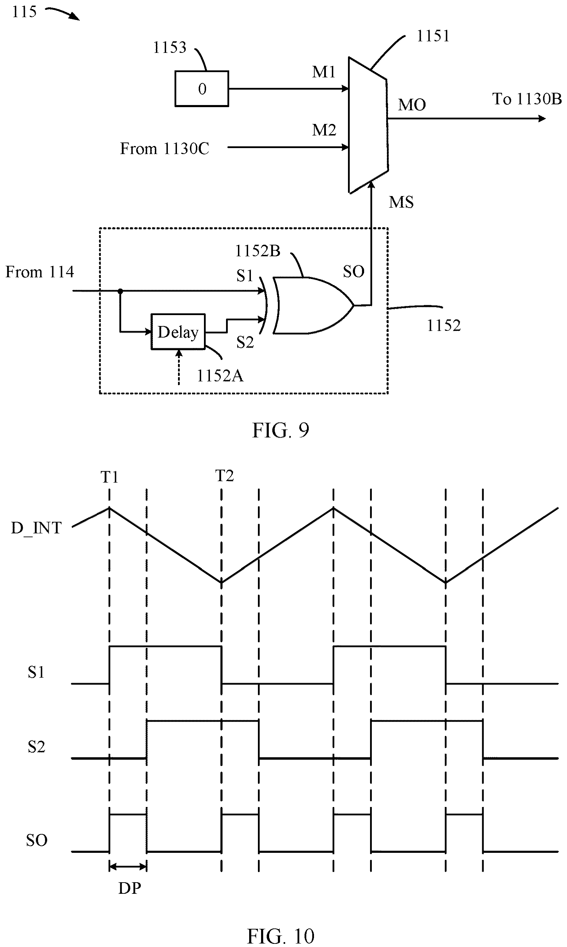

FIG. 9 is a block diagram of a selector 115 according to an embodiment of this disclosure. As shown in FIG. 9, the selector 115 may include a multiplexer 1151 and a jump detection circuit 1152. The multiplexer 1151 includes a first input end M1, a second input end M2, an output end MO, and a selection end MS. The first input end M1 receives a constant signal, for example, a constant signal representing zero, from a signal generator 1153. The second input end M2 receives a slope signal generated by a slope branch 113C, for example, a slope signal output from an adder 1130C of the slope branch 113C. The output end MO is coupled to an integration branch 113B, for example, outputs a signal to an adder 1130B of the integration branch 113B to superimpose with a signal in the integration branch 113B. The selection end MS of the multiplexer 1151 is coupled to a jump detection circuit 1152 to receive a selection signal. The multiplexer 1151 is configured to connect the first input end M1 to the output end MO based on the selection signal input to the selection end MS is at a first level (for example, a high level), to output the constant signal, and connect the second input end M2 to the output end MO based on the selection signal input to the selection end MS is at a second level (for example, a low level), to output the slope signal The jump detection circuit 1152 is configured to: in response to a frequency change detection circuit 114 indicating that a frequency change direction changes, output the selection signal at the first level to the selection end MS of the multiplexer 1151 for a predetermined time period, so that the multiplexer 1151 outputs the constant signal to the output end of the multiplexer 1151 during the predetermined time period, to invalidate the slope branch 113C. The jump detection circuit 1152 is further configured to output the selection signal at the second level to the selection end MS in another time period other than the predetermined time period, so that the multiplexer 1151 combines the slope branch 113C into the multi-order filter 113 in the another time period, to implement multi-order filtering including a slope operation in the another time period.

In some embodiments of this disclosure, the jump detection circuit 1152 includes a delay circuit 1152A and an exclusive-OR logic part 1152B. The delay circuit 1152A is configured to delay, by duration of the predetermined time period, a signal indicating the frequency change direction, and the exclusive-OR logic part 1152B is configured to perform an exclusive-OR operation on the signal indicating the frequency change direction and the delayed signal to generate the selection signal. In an example, an input end S1 and an input end S2 of the exclusive-OR logic part 1152B are respectively connected to an output end of the frequency change detection circuit 114 and an output end of the delay circuit 1152, and an input end of the delay circuit 1152 is also connected to the frequency change detection circuit 114. In this way, a decision signal output by the frequency change detection circuit 114 is provided for the input end S1 of the exclusive-OR logic part 1152B, and the decision signal is provided for the other input end S2 of the exclusive-OR logic part 1152B after being delayed. An exclusive-OR result of the exclusive-OR logic part 1152B is provided as the selection signal to the selection end of the multiplexer 1151.

FIG. 10 is a waveform diagram of a first integrated signal D_INT and an input signal and an output signal of an exclusive-OR logic part 1152B according to an embodiment of this disclosure. Four waveform diagrams sequentially indicate the first integrated signal D_INT, an input signal at an input end S1 of the exclusive-OR logic part 1152B, an input signal at an input end S2 of the exclusive-OR logic part 1152B, and an output signal at an output end SO of the exclusive-OR logic part 1152B from top to bottom.

Before a moment T1, the first integrated signal D_INT indicating a frequency change of a spread spectrum clock gradually increases. Therefore, a frequency change detection circuit 114 outputs a low-level signal to the input end S1 of the exclusive-OR logic part 1152B, that is, the input end S1 is at a low level. At the moment T1, a frequency change direction of the spread spectrum clock changes, and a change from gradually increasing a frequency to gradually decreasing a frequency occurs. Therefore, the input end S1 jumps from the low level to a high level. Between the moment T1 and a moment T2, the input end S1 remains at the high level; and at the moment T2 and after the moment T2, the input end S1 cyclically jumps between the high level and the low level as the frequency of the spread spectrum clock periodically changes.

At the input end S2, the delay circuit 1152 delays the signal at the input end S1 by a period of time DP based on a preset setting, where the DP corresponds to a predetermined time period for which a slope branch 113C needs to be invalidated. Therefore, the signal at the input end S2 lags behind the signal at the input end S1 by the period of time DP. At the output end SO, a pulse with a pulse width of the DP is output after an exclusive-OR operation is performed on the signal at the input end S1 and the signal at the input end S2, and the pulse closely follows a jump moment at which the frequency change direction changes.

Therefore, a multiplexer 1151 may provide a constant signal for an output end of the multiplexer 1151 during a high-level pulse with the pulse width of the DP based on the signal at the output SO, and provide, during the low level, a slope signal generated by the slope branch 113C for the output end of the multiplexer 1151. In this manner, the slope branch 113C may be removed or decoupled from a multi-order filter 111 for the predetermined time period when the frequency change direction of the spread spectrum clock changes, to alleviate or eliminate an overshoot problem.

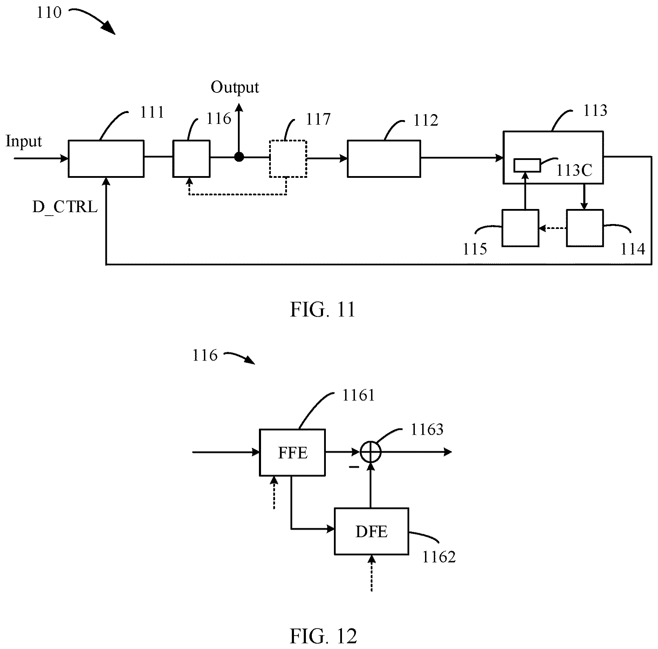

FIG. 11 is a block diagram of a data and clock recovery circuit 110 according to another embodiment of this disclosure. Different from FIG. 4, the data and clock recovery circuit 110 shown in FIG. 11 may further include an equalizer 116, and the equalizer 116 is configured to equalize a sampled signal. In addition, a phase detector 112 may determine a phase difference in the sampled signal based on an equalized sampled signal. In an example, in some application scenarios such as a 10G vehicle-mounted physical layer (physical layer, PHY) system, a transmission channel condition is poor and inter-symbol interference is severe, which further increases difficulty of tracking and recovering data and a clock on a receiving side by a circuit system in a spread spectrum mode. Therefore, the equalizer 116 may be configured to equalize a high-frequency component and a low-frequency component in the sampled signal, to compensate for inter-symbol interference caused by link transmission, thereby effectively improving tracking precision.

In some embodiments of this disclosure, the data and clock recovery circuit 110 may further include a decider 117, and the decider 117 determines a decision value of the sampled signal based on the equalized sampled signal. In addition, the phase detector 112 is further configured to determine the phase difference in the sampled signal based on the determined decision value. The decision value is used as an input of the phase detector 112, so that precision of the phase detector can be further improved, thereby improving overall performance of the circuit. In some embodiments, the equalizer 116 is further configured to equalize the sampled signal based on the decision value that is fed back. In other words, the decider 117 may feed back the decision value to the equalizer 116 to help set an equalization parameter of the equalizer 116, thereby improving an equalization result.

FIG. 12 is a block diagram of an equalizer 116 according to an embodiment of this disclosure. As shown in FIG. 12, in some embodiments of this disclosure, the equalizer 116 may include a feed forward equalization part (feed forward equalizer, FFE) 1161, a feedback equalization part (decision feedback equalizer, DFE) 1162, and a second adder 1163. The feed forward equalization part 1161 generates a feed forward equalized signal based on a sampled signal, the feedback equalization part 1162 generates a feedback equalized signal based on the feed forward equalized signal, and the second adder 1163 calculates a difference between the feed forward equalized signal and the feedback equalized signal to generate an equalized sampled signal. In an example, the feed forward equalization part 1161 may enhance a high-frequency component attenuated in a transmission process, and the feedback equalization part 1162 and the second adder 1163 may further filter out noise in the high-frequency component based on the feed forward equalization part 1161, to improve the sampled signal generated by a sampler 111, and improve tracking precision. In an embodiment, a decider 117 may feed back a decision value to the feed forward equalization part 1161 and the feedback equalization part 1162, to help set an equalization parameter of the feed forward equalization part 1161 and the feedback equalization part 1162 to improve an equalization result.

In embodiments of this disclosure, an improved solution for recovering data and a clock is provided. By using a combination of multi-order filtering including a slope branch, a frequency change detection circuit, and a selector, overshoot in a recovery process can be alleviated or eliminated and a tracking speed and tracking precision of a spread spectrum clock can be improved when a circuit system uses a spread spectrum clocking technology. In addition, in the solution of this disclosure, an equalizer and a decider may be further used to improve phase detection precision of a phase detector, thereby further improving the tracking precision. The solution of this disclosure is applicable to the field of vehicle-mounted communication in which a transmission channel is poor. In addition, in PAM4 and higher-order modulation and in a bidirectional symmetric system, the solution can be used to recover a clock signal with high precision, to improve overall performance of a signal receiving end and a system.

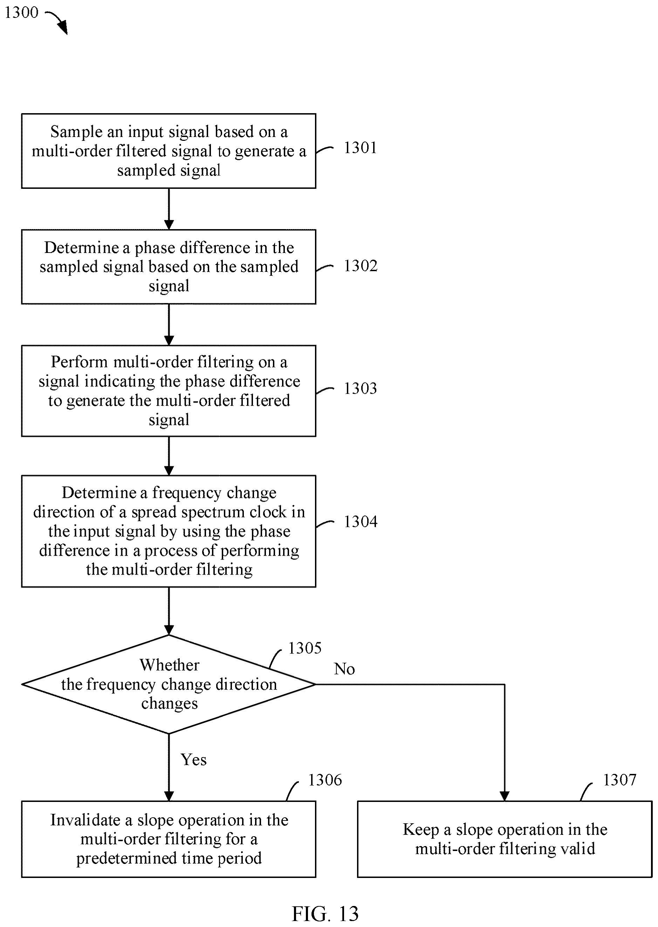

With reference to FIG. 1, FIG. 2, and FIG. 4 to FIG. 12, the foregoing describes in detail the data and clock recovery circuit 110 provided in this application, the receiving apparatus 100 including the data and clock recovery circuit 110, the circuit system 1000, the vehicle-mounted device 11, and the vehicle 10. With reference to FIG. 13 to FIG. 15, the following describes a method provided based on the data and clock recovery circuit 110 in this application.

FIG. 13 is a schematic flowchart of a data and clock recovery method 1300 according to an embodiment of this disclosure. The method 1300 may be implemented in the data and clock recovery circuit 110 in FIG. 2, FIG. 4, and FIG. 11. It may be understood that the foregoing aspects described in FIG. 1, FIG. 2, and FIG. 4 to FIG. 12 is applicable to the method 1300. For purposes of discussion, the method 1300 is described with reference to FIG. 1,

FIG. 2, and FIG. 4 to FIG. 12.

At block 1301, a sampler 111 samples an input signal based on a multi-order filtered signal D_CTRL to generate a sampled signal. In some embodiments, the sampling an input signal based on a multi-order filtered signal D_CTRL to generate a sampled signal includes: A controlled oscillator or a phase interpolator 1111 determines a sampling frequency based on the multi-order filtered signal D_CTRL; and an analog-to-digital converter 1112 samples the input signal at the determined sampling frequency.

At block 1302, a phase detector 112 determines a phase difference in the sampled signal based on the sampled signal.

At block 1303, a multi-order filter 113 performs multi-order filtering on a signal representing the phase difference to generate the multi-order filtered signal D_CTRL.

At block 1304, a frequency change detection circuit 114 determines a frequency change direction of a spread spectrum clock in the input signal by using the phase difference in a process of performing the multi-order filtering. In some embodiments, the multi-order filtering includes a proportion operation and an integration operation, and the determining a frequency change direction of a spread spectrum clock in the input signal by using the phase difference includes: determining the frequency change direction based on a first integrated signal D_INT generated by the integration operation.

At block 1305, a selector 115 determines whether the frequency change direction changes.

At block 1306, the selector 115 invalidates a slope operation in the multi-order filtering for a predetermined time period in response to a change of the frequency change direction. In some embodiments, the invalidating a slope operation in the multi-order filtering for a predetermined time period in response to a change of the frequency change direction includes: The selector 115 superimposes a constant signal into the integration operation for the predetermined time period in response to the change of the frequency change direction. In some embodiments, the predetermined time period is associated with duration of overshoot caused by the slope operation when the frequency change direction changes.

At block 1307, the slope operation in the multi-order filtering is kept valid in response to no change of the frequency change direction. In some embodiments, that the slope operation in the multi-order filtering is kept valid in response to no change of the frequency change direction may further include: The selector 115 superimposes, into the integration operation in another time period other than the predetermined time period, a slope signal generated by the slope operation.

In some embodiments of this disclosure, the method 1300 further includes: An equalizer 116 equalizes the sampled signal, and the determining a phase difference in the sampled signal based on the sampled signal includes: determining the phase difference in the sampled signal based on an equalized sampled signal. In some embodiments, the equalizing the sampled signal includes: A feed forward equalization part 1161 performs feed forward equalization on the sampled signal to generate a feed forward equalized signal. A feedback equalization part 1162 performs feedback equalization on the feed forward equalized signal to generate a feedback equalized signal. A second adder 1163 calculates a difference between the feed forward equalized signal and the feedback equalized signal to generate the equalized sampled signal.

In some embodiments of this disclosure, the method 1300 further includes: A decider 117 determines a decision value of the sampled signal based on the equalized sampled signal. The determining a phase difference in the sampled signal based on the sampled signal includes: The phase detector 112 determines the phase difference in the sampled signal based on the decision value. The equalizing the sampled signal includes: The equalizer 116 equalizes the sampled signal based on the decision value that is fed back.

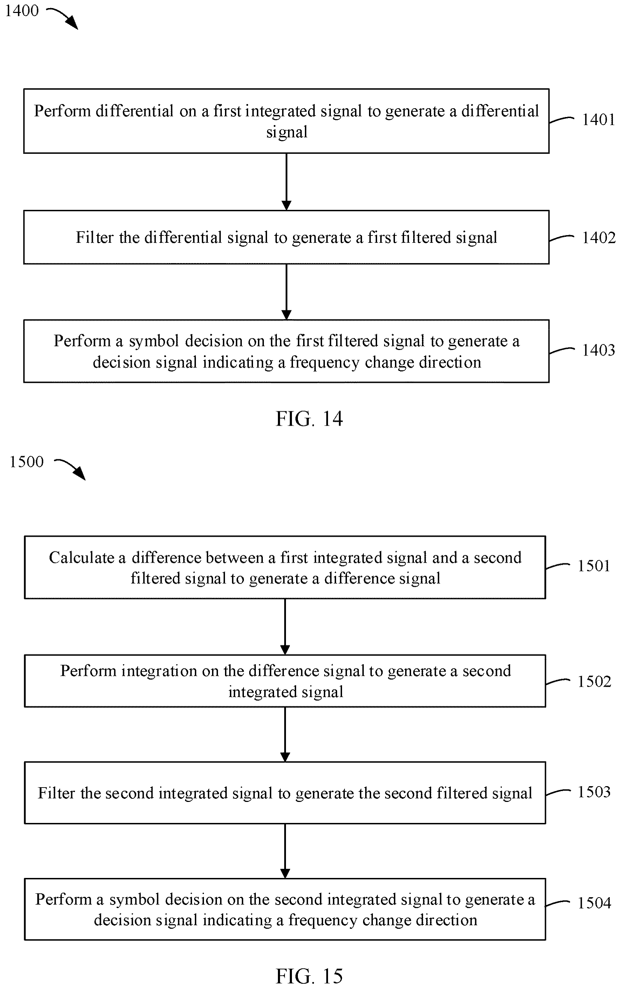

FIG. 14 is a schematic flowchart of a method 1400 for determining a frequency change direction of a spread spectrum clock according to an embodiment of this disclosure. The method 1400 may be implemented at block 1304 in FIG. 13.

At block 1401, a differentiator 1145 performs differential on a first integrated signal D_INT to generate a differential signal.

At block 1402, a first filter 1146 filters the differential signal to generate a first filtered signal.

At block 1403, a first symbol decider 1147 performs a symbol decision on the first filtered signal to generate a decision signal indicating the frequency change direction.

FIG. 15 is a schematic flowchart of another method 1500 for determining a frequency change direction of a spread spectrum clock according to an embodiment of this disclosure. The method 1500 may be implemented at block 1304 in FIG. 13.

At block 1501, a first adder 1141 calculates a difference between a first integrated signal D_INT and a second filtered signal to generate a difference signal.

At block 1502, an integrator 1142 performs integration on the difference signal to generate a second integrated signal.

At block 1503, a second filter 1143 filters the second integrated signal to generate a second filtered signal.

At block 1504, a second symbol decider 1144 performs a symbol decision on the second integrated signal to generate a decision signal indicating the frequency change direction.

In addition, although operations are described in a particular order, it should be understood as that it is required that the operations are performed in the shown particular order or in sequence, or it is required that all operations shown in the figures should be performed to achieve an expected result. In a specific environment, multi-task and parallel processing may be advantageous. Similarly, although several specific implementation details are included in the foregoing description, these should not be construed as limiting the scope of this disclosure. Some features described in the context of an individual embodiment may alternatively be implemented in combination in a single implementation. On the contrary, various features described in the context of a single implementation may alternatively be implemented in a plurality of implementations individually or in any appropriate sub-combination.

Although the subject matter is described in a language specific to structural features and/or method logic actions, it should be understood that the subject matter defined in the appended claims is not necessarily limited to the particular features or actions described above. On the contrary, the particular features and actions described above are merely example forms for implementing the claims.

## Claims

1. A data and clock recovery circuit (110), comprising:
a sampler (111), configured to sample an input signal based on a multi-order filtered signal (D_CTRL) to generate a sampled signal;
a phase detector (112), configured to determine a phase difference in the sampled signal based on the sampled signal;
a multi-order filter (113), configured to generate the multi-order filtered signal (D_CTRL) based on the phase difference;
a frequency change detection circuit (114), configured to determine a frequency change direction of a spread spectrum clock in the input signal by using the phase difference; and
a selector (115), configured to: in response to the frequency change detection circuit (114) indicating that the frequency change direction changes, invalidate a slope branch (113C) in the multi-order filter (113) for a predetermined time period.

2. The data and clock recovery circuit (110) according to claim 1, wherein the multi-order filter (113) further comprises a proportion branch (113A) and an integration branch (113B), and the frequency change detection circuit (114) is configured to determine the frequency change direction based on a first integrated signal (D_INT) generated by the integration branch (113B).

3. The data and clock recovery circuit (110) according to claim 2, wherein the frequency change detection circuit (114, 700) comprises:
a differentiator (1145), configured to generate a differential signal based on the first integrated signal (D_INT);
a first filter (1146), configured to generate a first filtered signal based on the differential signal; and
a first symbol decider (1147), configured to generate, based on the first filtered signal, a decision signal indicating the frequency change direction.

4. The data and clock recovery circuit (110) according to claim 2, wherein the frequency change detection circuit (114, 800) comprises:
a first adder (1141), configured to calculate a difference between the first integrated signal (D_INT) and a second filtered signal to generate a difference signal;
an integrator (1142), configured to generate a second integrated signal based on the difference signal;
a second filter (1143), configured to generate the second filtered signal based on the second integrated signal; and
a second symbol decider (1144), configured to generate, based on the second integrated signal, a decision signal indicating the frequency change direction.

5. The data and clock recovery circuit (110) according to claim 2, wherein the selector (115) comprises:
a multiplexer (1151), comprising a first input end (M1) for receiving a constant signal, a second input end (M2) for receiving a slope signal generated by the slope branch, an output end (MO), and a selection end (MS), wherein the multiplexer is configured to separately output the constant signal or the slope signal at the output end (MO) based on that a selection signal input to the selection end (MS) is a first level or a second level; and
a jump detection circuit (1152), configured to: in response to the frequency change detection circuit (114) indicating that the frequency change direction changes, output a selection signal of the first level to the selection end (MS) for the predetermined time period, and output a selection signal of the second level to the selection end (MS) in another time period other than the predetermined time period.

6. The data and clock recovery circuit (110) according to claim 5, wherein the jump detection circuit (1152) comprises:
a delay circuit (1152A), configured to delay, by duration of the predetermined time period, a signal indicating the frequency change direction; and
an exclusive-OR logic part (1152B), configured to perform an exclusive-OR operation on the signal indicating the frequency change direction and the delayed signal to generate the selection signal.

7. The data and clock recovery circuit (110) according to claim 1, further comprising an equalizer (116), configured to equalize the sampled signal, wherein
the phase detector is further configured to determine the phase difference in the sampled signal based on an equalized sampled signal.

8. The data and clock recovery circuit (110) according to claim 7, wherein the equalizer (116) comprises:
a feed forward equalization part (1161), configured to generate a feed forward equalized signal based on the sampled signal;
a feedback equalization part (1162), configured to generate a feedback equalized signal based on the feed forward equalized signal; and
a second adder (1163), configured to calculate a difference between the feed forward equalized signal and the feedback equalized signal to generate the equalized sampled signal.

9. The data and clock recovery circuit (110) according to claim 7 or 8, further comprising a decider (117), configured to determine a decision value of the sampled signal based on the equalized sampled signal, wherein
the phase detector is further configured to determine the phase difference in the sampled signal based on the decision value, and
the equalizer (116) is further configured to equalize the sampled signal based on the decision value that is fed back.

10. The data and clock recovery circuit (110) according to claim 1, wherein the predetermined time period is associated with overshoot duration of a slope signal generated by the slope branch (113C) when the frequency change direction changes.

11. The data and clock recovery circuit (110) according to claim 1, wherein the sampler (111) comprises:
a controlled oscillator or a phase interpolator (1111), configured to determine a sampling frequency based on the multi-order filtered signal (D_CTRL); and
an analog-to-digital converter (1112), configured to sample the input signal at the determined sampling frequency.

12. A receiving apparatus (100), comprising:
the data and clock recovery circuit (110) according to any one of claims 1 to 11, and
a data processing circuit, configured to process data output by the data and clock recovery circuit.

13. A circuit system (1000), comprising:
the receiving apparatus (100) according to claim 12, and
a sending apparatus (200), configured to transmit a signal to the receiving apparatus (100) in a clock spread spectrum manner.

14. A vehicle-mounted device (11), comprising:
a circuit board, and
the receiving apparatus (100) according to claim 12, mounted on the circuit board.

15. A vehicle (10), comprising:
the vehicle-mounted device (11) according to claim 14, and
a power supply apparatus, configured to supply power to the vehicle-mounted device.

16. A data and clock recovery method, comprising:
sampling an input signal based on a multi-order filtered signal (D_CTRL) to generate a sampled signal;
determining a phase difference in the sampled signal based on the sampled signal;
performing multi-order filtering on a signal indicating the phase difference to generate the multi-order filtered signal (D_CTRL);
determining a frequency change direction of a spread spectrum clock in the input signal by using the phase difference in a process of performing the multi-order filtering; and
invalidating a slope operation in the multi-order filtering for a predetermined time period in response to a change of the frequency change direction.

17. The method according to claim 16, wherein the multi-order filtering further comprises a proportion operation
and an integration operation, and
the determining a frequency change direction of a spread spectrum clock in the input signal by using the phase difference comprises: determining the frequency change direction based on a first integrated signal (D_INT) generated by the integration operation.

18. The method according to claim 17, wherein the determining a frequency change direction of a spread spectrum clock in the input signal by using the phase difference comprises:
performing differential on the first integrated signal (D_INT) to generate a differential signal;
filtering the differential signal to generate a first filtered signal; and
performing a symbol decision on the first filtered signal to generate a decision signal indicating the frequency change direction.

19. The method according to claim 17, wherein the determining a frequency change direction of a spread spectrum clock in the input signal by using the phase difference comprises:
calculating a difference between the first integrated signal (D_INT) and a second filtered signal to generate a difference signal;
performing integration on the difference signal to generate a second integrated signal;
filtering the second integrated signal to generate the second filtered signal; and
performing a symbol decision on the second integrated signal to generate a decision signal indicating the frequency change direction.

20. The method according to claim 17, wherein the invalidating a slope operation in the multi-order filtering for a predetermined time period in response to a change of the frequency change direction comprises:
superimposing a constant signal into the integration operation for the predetermined time period in response to the change of the frequency change direction; and
the method further comprises: superimposing, into the integration operation in another time period other than the predetermined time period, a slope signal generated by the slope operation.

21. The method according to claim 16, further comprising:
equalizing the sampled signal; and
the determining a phase difference in the sampled signal based on the sampled signal comprises: determining the phase difference in the sampled signal based on an equalized sampled signal.

22. The method according to claim 21, wherein the equalizing the sampled signal comprises:
performing feed forward equalization on the sampled signal to generate a feed forward equalized signal;
performing feedback equalization on the feed forward equalized signal to generate a feedback equalized signal; and
calculating a difference between the feed forward equalized signal and the feedback equalized signal to generate the equalized sampled signal.

23. The method according to claim 21 or 22, further comprising:
determining a decision value of the sampled signal based on the equalized sampled signal;
the determining a phase difference in the sampled signal based on the sampled signal comprises: determining the phase difference in the sampled signal based on the decision value; and
the equalizing the sampled signal comprises: equalizing the sampled signal based on the decision value that is fed back.

24. The method according to claim 16, wherein the predetermined time period is associated with duration of overshoot caused by the slope operation when the frequency change direction changes.

25. The method according to claim 16, wherein the sampling an input signal based on a multi-order filtered signal (D_CTRL) to generate a sampled signal comprises:
determining a sampling frequency based on the multi-order filtered signal (D_CTRL); and
sampling the input signal at the determined sampling frequency.
